# EUROPEAN PATENT APPLICATION

(11) **EP 4 509 922 A1**
(43) Date of publication of application: **19.02.2025**
(21) Application number: 24191246.8
(22) Date of filing: 26.07.2024
(51) Int. Cl.: G03F 1/24

(54) **REFLECTIVE MASK BLANK AND MANUFACTURING METHOD OF REFLECTIVE MASK**

(30) Priority: 16.08.2023 JP 2023132457
(71) Applicant: Shin-Etsu Chemical Co., Ltd., Chiyoda-ku, Tokyo 1000005 (JP)
(72) Inventor: INAZUKI, Yukio, Joetsu-shi, 9428601 (JP); KOSAKA, Takuro, Joetsu-shi, 9428601 (JP); OGOSE, Taiga, Joetsu-shi, 9428601 (JP); SAKURAI, Keisuke, Joetsu-shi, 9428601 (JP); MIMURA, Shohei, Joetsu-shi, 9428601 (JP); KANEKO, Hideo, Joetsu-shi, 9428601 (JP)
(74) Representative: Mewburn Ellis LLP

(57) **Abstract**

A fine and preferable pattern of an absorption film can be formed from the absorption film that can be patterned by dry etching using a gas containing oxygen (O) by a reflective mask blank including a substrate, a multilayer reflection film that is formed on one main surface of the substrate, and reflects exposure light, an absorption film that is formed on the multilayer reflection film, and absorbs the exposure light, and an etching mask film containing niobium (Nb) on the absorption film.

## Description

### TECHNICAL FIELD

The present invention relates to a reflective mask blank which is a material for a reflective mask used in manufacturing semiconductor devices such as LSIs, and a method of manufacturing a reflective mask from the reflective mask blank.

### BACKGROUND

In a manufacturing process of a semiconductor device, a photolithography technique in which a circuit pattern formed on a transfer mask is transferred onto a semiconductor substrate (a semiconductor wafer) through a reduction projection optical system with irradiating exposure light to the transfer mask is repeatedly used. Conventionally, a mainstream wavelength of the exposure light is 193 nm by argon fluoride (ArF) excimer laser light. A pattern with dimensions smaller than exposure wavelength has finally been formed by adopting a process called multi-patterning in which exposure processes and processing processes are combined multiple times.

However, since it is necessary to form further fine patterns under continuous miniaturization of device patterns, an extreme ultraviolet lithography technique utilizing, as exposure light, extreme ultraviolet (here after refers to as "EUV") light having a shorter wavelength than the wavelength of ArF excimer laser light has been used. The EUV light has a wavelength of about 0.2 to 100 nm, in particular, is light having a wavelength of around 13.5 nm. The EUV light has a very low transparency to a substance and cannot be utilized for a conventional transmissive projection optical system or mask, thus, reflection type optical elemental devices are applied. Therefore, a reflective mask is also used as a mask for the pattern transfer.

In the reflective mask, a multilayer reflection film that reflects EUV light is formed on a substrate, and a pattern of an absorption film that absorbs EUV light is formed on the multilayer reflection film. On the other hand, a material (including also a material in which a resist layer is formed) before patterning the absorption film is called a reflective mask blank, and is used as a material for the reflective mask. The reflective mask blank commonly has a basic structure that includes a low thermal expansion substrate, a multilayer reflection film that is formed on either of the two main surfaces of the substrate and reflects EUV light, and an absorption film that is formed thereon and absorbs EUV light.

As the multilayer reflection film, a multilayer reflection film in which molybdenum (Mo) layers and silicon (Si) layers are alternately laminated to has a necessary reflectance for EUV light is commonly used. On the other hand, as the absorption film, tantalum (Ta) or others, which have a relatively large extinction coefficient with respect to EUV light, is used (Patent Document 1: JP-A 2002-246299).

Further, as a protection film (capping film) for protecting the multilayer reflection film in such as cleaning the reflective mask, a ruthenium (Ru) film, as disclosed in Patent Document 2: JP-A 2002-122981, is formed on the multilayer reflection film. In some cases, a hard mask film containing chromium (Cr) is formed on the absorption film as an etching mask in patterning the absorption film. On the other hand, a conducting film is formed on the other main surface of the substrate. As the conducting film, a metal nitride film has been proposed for electrostatic chucking, and a film containing manly chromium (Cr) or tantalum (Ta) is exemplified.

### Citation List

Patent Document 1: JP-A 2002-246299
Patent Document 2: JP-A 2002-122981

### SUMMARY OF THE INVENTION

Tantalum (Ta)-based films are generally used for the absorption film. However, it is required that the pattern height which corresponds to film thickness of the absorption film is lowered, i.e., the thickness of the absorption film is thinned to improve accuracy in pattern transfer to a wafer by reducing shadowing effect in exposure using a reflective mask. Thus, attention has been focused on chromium (Cr)-based absorption films that can be thinned compared with the tantalum (Ta)-based absorption films.

The absorption film which is a chromium (Cr)-based film or others can be etched by dry etching using a gas containing chlorine (Cl) and oxygen (O). However, when the absorption film is etched by forming a resist film, forming a resist pattern from the resist film, and dry etching with using the resist pattern as an etching mask, it is necessary to form the resist pattern (resist film) thicker since the resist pattern is also etched in dry etching using a gas containing oxygen (O). On the other hand, in attempting to form a fine resist pattern from a thick resist film, the resist pattern will collapse since its aspect ratio is high. Therefore, the fine resist pattern cannot be formed, and a fine pattern of the absorption film cannot be formed.

The present invention has been made to solve the above problems, and an object of the present invention is to provide a reflective mask blank in which an absorption film that can be patterned by dry etching using a gas containing oxygen (O) is included, and from which a fine pattern of the absorption film can be suitably formed, and to provide a manufacturing method of a reflective mask with using the reflective mask blank.

The inventors have made earnestly studies to solve the above problems. As a result, the inventors found that the problems can be solved by providing an etching mask film containing niobium (Nb) on an absorption film consisting of a material that can be dry-etched by a gas containing oxygen (O), particularly, a gas containing chlorine (Cl) and oxygen (O).

In one aspect, the invention provides a reflective mask blank which is a material for a reflective mask used in EUV lithography utilizing EUV light as exposure light, including
a substrate,
a multilayer reflection film that is formed on one main surface of the substrate, and reflects the exposure light, and
an absorption film that is formed on the multilayer reflection film, and absorbs the exposure light, wherein
the absorption film consists of a material that can be dry-etched by a gas containing oxygen (O), and
the reflective mask blank includes an etching mask film containing niobium (Nb) on the absorption film.

Preferably, the etching mask film containing niobium (Nb) consists of simple niobium (Nb), or a niobium (Nb) compound containing niobium (Nb) and oxygen (O).

Preferably, the absorption film contains chromium (Cr) or ruthenium (Ru).

In the other aspect, the invention provides a manufacturing method of a reflective mask, including the step of:
pattering the absorption film of the reflective mask blank as described herein (e.g. of any one of claims 1 to 4) by dry etching using a gas containing oxygen (O).

Preferably, the method includes the steps of
patterning the etching mask film with using a resist pattern as an etching mask to form a pattern of the etching mask film, and
patterning the absorption film by dry etching using a gas containing oxygen (O) with using the pattern of the etching mask film as an etching mask.

Preferably, the method includes the step of:
after forming the pattern of the absorption film, removing the pattern of the etching mask film by sulfuric acid-hydrogen peroxide mixture (SPM).

### ADVANTAGEOUS EFFECTS

According to the invention, a fine and preferable pattern of an absorption film can be formed from the absorption film that can be patterned by dry etching using a gas containing oxygen (O).

### BRIEF DESCRIPTION OF THE DRAWINGS

FIG. 1 is a cross-sectional view illustrating an example of a reflective mask blank of the invention.
FIG. 2 is a cross-sectional view illustrating an example of a reflective mask of the invention.

### FURTHER EXPLANATIONS; OPTIONS AND PREFERENCES

A reflective mask blank of the invention includes a substrate, a multilayer reflection film that is formed on one main surface (front surface) of the substrate, and reflects exposure light, and an absorption film that is formed on the multilayer reflection film, and absorbs the exposure light. Further, the reflective mask blank of the invention includes an etching mask film on the absorption film.

The reflective mask blank of the invention is suitable for a material for a reflective mask used in EUV lithography utilizing EUV light as exposure light. A wavelength of EUV light used in EUV lithography utilizing EUV light as exposure light is 13 to 14 nm, commonly about 13.5 nm. A reflective mask blank and a reflective mask using EUV light as exposure light are also called an EUV mask blank and an EUV mask, respectively.

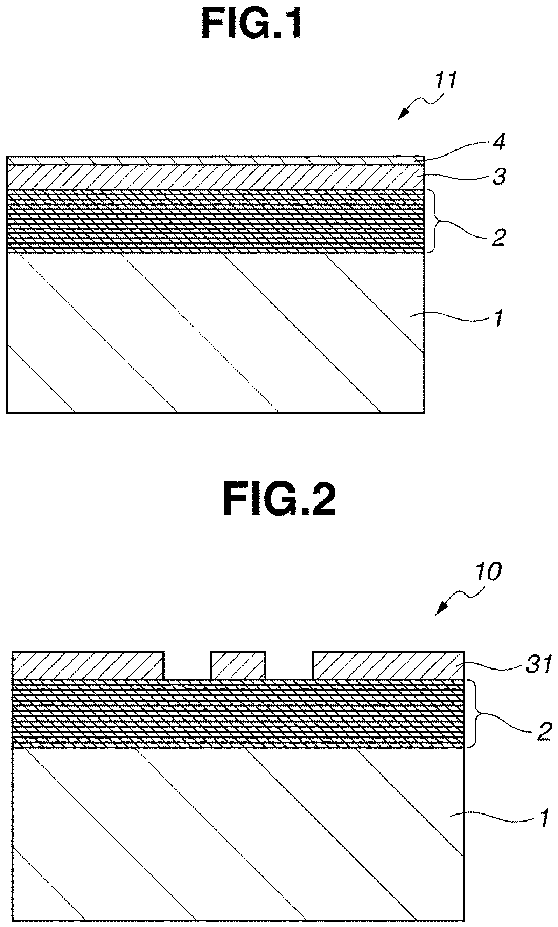

FIG. 1 is a cross-sectional view illustrating an example of a reflective mask blank of the invention. This reflective mask blank 11 includes a substrate 1, and on the substrate 1, a multilayer reflection film 2 that is formed in contact with the substrate 1, an absorption film 3 that is formed in contact with the multilayer reflection film 2, and an etching mask film 4 that is formed in contact with the absorption film 3.

For use in EUV light exposure, the substrate preferably has low thermal expansion property. For example, the substrate is preferably composed of a material having a coefficient of thermal expansion within ±2×10⁻⁸/°C, preferably within ±5×10⁻⁹/°C. As such a material, a titania-doped quartz glass (SiO₂-TiO₂-based glass) is exemplified. Further, a substrate having a sufficiently flattened surface is preferably used. The main surface of the substrate has a surface roughness, as an RMS value, of preferably not more than 0.5 nm, more preferably not more than 0.2 nm. Such a surface roughness can be obtained by polishing of the substrate, or others. The substrate preferably has dimensions of 152 mm-square in the main surface and 6.35 mm in thickness. A substrate having the dimensions is so-called a 6025 substrate, which has dimensions of 6 inches-square in the main surface and 0.25 inches in thickness.

The multilayer reflection film is a film that reflects exposure light, in the reflective mask. The multilayer reflection film is preferably formed in contact with one main surface of the substrate, however, may be formed via another film such as an underlayer film on the one main surface of the substrate. The multilayer reflection film has a periodically laminated structure in which high refractive index layers having a comparatively high refractive index with respect to exposure light and low refractive index layers having a comparatively low refractive index with respect to the exposure light are alternately laminated.

The high refractive index layer is preferably composed of a material containing silicon (Si). The high refractive index layer may contain at least one additive element selected from the group consisting of oxygen (O), nitrogen (N), carbon (C), boron (B) and hydrogen (H). Further, the high refractive index layer may be configured by a multilayer including a layer containing the additive element and a layer not containing the additive element. The high refractive index layer has a thickness of preferably not less than 3.5 nm, more preferably not less than 4 nm, and preferably not more than 4.9 nm, more preferably not more than 4.4 nm.

The low refractive index layer is preferably composed of a material containing molybdenum (Mo). The low refractive index layer may be composed of a material containing ruthenium (Ru). The low refractive index layer may contain at least one additive element selected from the group consisting of oxygen (O), nitrogen (N), carbon (C), boron (B) and hydrogen (H). Further, the low refractive index layer may be configured by a multilayer including a layer containing the additive element and a layer not containing the additive element. The low refractive index layer has a thickness of preferably not less than 2.1 nm, more preferably not less than 2.6 nm, and preferably not more than 3.5 nm, more preferably not more than 3 nm.

The periodically laminated structure may include the high refractive index layer and the low refractive index layer, and may include at least one high refractive index layer and at least one low refractive index layer in one cycle. The one cycle includes at least two layers and may be configured by, for example, one high refractive index layer and one low refractive index layer. Further, the one cycle may include at least two high refractive index layers that have different compositions (for example, different ratios in composition, or different compositions with or without an additive element) each other, and may include at least two low refractive index layers that have different compositions (for example, different ratios in composition, or different compositions with or without an additive element) each other. In this case, the one cycle includes at least three layers and may include four or five or more layers, however, preferably not more than eight layers. The periodically laminated structure has the cycles of preferably not less than 30 cycles, and preferably not more than 50 cycles, more preferably not more than 40 cycles. In the case that the low refractive index layer is composed of a material containing ruthenium (Ru), the layer remotest from the substrate (uppermost layer) in the periodically laminated structure is preferably the high refractive index layer. Further, in the case that the absorption film is contacted with the multilayer reflection film, and the absorption film is an absorption film containing chromium (Cr) described later, it is preferable that the layer remotest from the substrate (uppermost layer) in the periodically laminated structure is the silicon (Si) layer since an etching selectivity is high in dry etching of the absorption film.

A thickness of the multilayer reflection film having the periodically laminated structure is adjusted according to an exposure wavelength and an incident angle of the exposure light, and has a thickness of preferably not less than 200 nm, more preferably not less than 270 nm, and preferably not more than 400 nm, more preferably not more than 290 nm.

Examples of methods for forming the multilayer reflection film include a sputtering method in which, to perform sputtering, power is supplied to a target, and plasma of an atmospheric gas is formed (an atmospheric gas is ionized) by the supplied power, and an ion beam sputtering method in which a target is irradiated with ion beam. The sputtering methods include a DC sputtering method in which a DC voltage is applied to a target, and an RF sputtering method in which a high frequency voltage is applied to a target. The sputtering method is a film forming method that utilizes sputtering phenomenon caused by gas ions generated by applying a voltage to a target with feeding a sputtering gas into a chamber to ionize the gas. Particularly, a magnetron sputtering method has an advantage in productivity. The power may be applied to the target by a DC system or an RF system. The DC system includes also a pulse sputtering in which a negative bias applied to the target is inverted for a short time to prevent charge-up of the target.

The multilayer reflection film may be formed by, for example, a sputtering method using a sputtering apparatus to which a plurality of targets can be attached. In particular, the multilayer reflection film may be formed with using, as targets, targets appropriately selected from the group consisting of a molybdenum (Mo) target for forming a molybdenum (Mo)-containing layer, a ruthenium (Ru) target for forming a ruthenium (Ru)-containing layer, a silicon (Si) target for forming a silicon (Si)-containing layer, and other targets, and with using, as a sputtering gas, a rare gas such as helium (He) gas, argon (Ar) gas, krypton (Kr) gas and xenon (Xe) gas.

Further, in the case that the sputtering is reactive sputtering using a reactive gas, for example, a nitrogen-containing gas such as nitrogen (N₂) gas to form a nitrogen (N)-containing film, an oxygen-containing gas such as oxygen (O₂) gas to form an oxygen (O)-containing film, a nitrogen oxide gas such as nitrous oxide (N₂O) gas, nitrogen monoxide (NO) gas and nitrogen dioxide (NO₂) gas to form a nitrogen (N) and oxygen (O)-containing film, a carbon oxide gas such as carbon monoxide (CO) gas and carbon dioxide (CO₂) gas to form a carbon (C) and oxygen (O)-containing film, a hydrogen-containing gas such as hydrogen (H₂) gas to form a hydrogen (H)-containing film, or a hydrocarbon gas such as methane (CH₄) gas to form a carbon (C) and hydrogen (H)-containing film may be used with the rare gas.

Moreover, a molybdenum (Mo) target added with boron (B) (a molybdenum boride (MoB) target), or a silicon (Si) target added with boron (B) (a silicon boride (SiB) target) may be used to form a boron (B)-containing layer.

The reflective mask blank of the invention may include a protection film for protecting the multilayer reflection film between the multilayer reflection film and the absorption film. The protection film is also called a capping film. The protection film is a film for protecting the multilayer reflection film. The protection film is generally formed in contact with the multilayer reflection film. Further, the protection film may be formed in contact with the absorption film, or in contact with another film (for example, an etching prevention film described later) that is contacted with the absorption film.

The protection film is composed of a material containing ruthenium (Ru). Examples of the materials containing ruthenium (Ru) include simple substance of ruthenium (Ru), and an alloy containing ruthenium (Ru) and another metal or metalloid different from ruthenium (Ru). Examples of the other metals or metalloids different from ruthenium (Ru) include niobium (Nb), rhenium (Re), zirconium (Zr), titanium (Ti), chromium (Cr), silicon (Si) and others. Among the materials containing ruthenium (Ru), simple substance of ruthenium (Ru) or an alloy containing ruthenium (Ru) and niobium (Nb) is particularly preferred. Further, in the case that an absorption film consisting of a material containing chromium (Cr) described later is formed in contact with the protection film, it is preferable that the protection film is a film containing ruthenium (Ru) and niobium (Nb) since an etching selectivity is high in dry etching of the absorption film. A content of the other metal or metalloid different from ruthenium (Ru) in the protection film is preferably not more than 30 at%, more preferably not more than 20 at% on average for the whole of the film. A lower limit of the content of the other metal or metalloid different from ruthenium (Ru) in the protection film is preferably not less than 5 at%, more preferably not less than 10 at% on average for the whole of the film, however, not limited particular thereto.

The protection film may have a single layer structure or a multilayer structure combining multiple layers having different compositions. Further, each layer constituting the single layer or the multiple layers may have a compositional graded structure in which composition continuously varies along the thickness direction. Particularly, in the protection film, either or both of the side close to the multilayer reflection film (the layer close to the multilayer reflection film in the case of the multilayer structure), and the side remotest from the multilayer reflection film (the layer remotest from the multilayer reflection film in the case of the multilayer structure) may consist of ruthenium (Ru).

In the case that the protection film has a multilayer structure or a compositional graded structure, the other metal or metalloid different from ruthenium (Ru) preferably has a content that increases from the multilayer reflection film side to the side remote from the multilayer reflection film in a part of or the whole of the protection film in the thickness direction. Particularly, in the case that niobium (Nb) is contained as the other metal or metalloid different from ruthenium (Ru), niobium (Nb) is effective to improve resistance to dry etching using a gas containing chlorine (Cl) and oxygen (O). Therefore, niobium (Nb) preferably has a content that increases from the multilayer reflection film side to the side remote from the multilayer reflection film in a part of or the whole of the protection film in the thickness direction.

As the dry etching using a gas containing chlorine (Cl) and oxygen (O), in particular, dry etching using a gas containing chlorine (Cl₂) gas and oxygen (O₂) gas is exemplified in the invention. The gas containing chlorine (Cl) and oxygen (O) may contain a rare gas such as helium (He) gas, argon (Ar) gas, krypton (Kr) gas and xenon (Xe) gas.

The protection film has a thickness of preferably not less than 2 nm, more preferably not less than 3 nm, and preferably not more than 5 nm, more preferably not more than 4 nm.

The protection film can be formed by sputtering using, as a target, an appropriate target selected from the group consisting of a ruthenium (Ru) target, a target of the other metal or metalloid different from ruthenium (Ru), in particular, a niobium (Nb) target, a rhenium (Re) target, a zirconium (Zr) target, a titanium (Ti) target, a chromium (Cr) target, a silicon (Si) target, a target in which two or more selected from the group consisting of niobium (Nb), rhenium (Re), zirconium (Zr), titanium (Ti), chromium (Cr) and silicon (Si) are mixed, and a target in which ruthenium (Ru) is mixed with at least one other metal or metalloid different from ruthenium (Ru) selected from the group consisting of niobium (Nb), rhenium (Re), zirconium (Zr), titanium (Ti), chromium (Cr) and silicon (Si), and using, as a puttering gas, a rare gas such as helium (He) gas, argon (Ar) gas, krypton (Kr) gas and xenon (Xe) gas. The sputtering is preferably performed by a magnetron sputtering method.

In the reflective mask, the absorption film is a film that absorbs exposure light and reduces reflectance. In the reflective mask, a transfer pattern is formed by a difference in reflectance between a portion where an absorption film is formed and a portion where an absorption film is not formed. The absorption film may consist of a single layer or multiple layers, and an antireflection layer may be formed on the surface of the absorption film.

The absorption film consists of a material that can be dry-etched by a gas containing oxygen (O). The absorption film is a film that can absorb EUV light and is composed of a material processable to a pattern. The absorption film is preferably composed of a material containing chromium (Cr) or ruthenium (Ru).

As the dry etching using a gas containing oxygen (O), dry etching using a gas containing oxygen (O₂) gas is exemplified in the invention. Particularly, dry etching using a gas containing oxygen (O) and being free of other gases except for rare gases, or dry etching using a gas containing a halogen and a gas containing oxygen (O) (in particular, oxygen (O₂) gas) is preferable. Examples of the halogens include chlorine (Cl) and fluorine (F). Examples of gases containing chlorine (Cl) include chlorine (Cl₂) gas and hydrogen chloride (HCl) gas, and examples of gases containing fluorine (F) include carbon tetrafluoride (CF₄) gas or sulfur hexafluoride (SF₆) gas. The gas containing oxygen (O) may contain a rare gas such as helium (He) gas, argon (Ar) gas, krypton (Kr) gas and xenon (Xe) gas.

The material containing chromium (Cr) may contain oxygen (O), nitrogen (N), carbon (C) or other elements. Examples of the materials containing chromium (Cr) include simple substance of Cr, and a chromium (Cr) compound such as CrO, CrN, CrON, CrC, CrCO, CrCN, and CrCON. Further, the material containing chromium (Cr) may contain another element as long as the material can be dry-etched by a gas containing oxygen (O). In addition, the description of the chemical formula of a metal or metalloid compound indicates the constituent elements of the compound, and does not mean their composition ratio. (The same applies below.)

The material containing ruthenium (Ru) may contain oxygen (O), nitrogen (N), carbon (C), boron (B) or other elements. Examples of the materials containing ruthenium (Ru) include simple substance of Ru, and a ruthenium (Ru) compound such as RuO, RuN, RuON, RuC, RuCO, RuCN, RuCON, RuB, RuOB, RuNB, RuONB, RuCB, RuCOB, RuCNB and RuCONB. Further, the material containing ruthenium (Ru) may contain another element as long as the material can be dry-etched by a gas containing oxygen (O).

The absorption film has an etching selectivity to the protection film of preferably not less than 3, more preferably not less than 5. The absorption film has a sheet resistance of preferably not more than 1×10⁶ Ω/square, more preferably not more than 1×10⁵ Ω/square. The absorption film has a surface roughness Sq of preferably not more than 0.8 nm, more preferably not more than 0.6 nm.

The absorption film (each layer constituting the absorption film) can be formed by sputtering, and the sputtering is preferably performed by a magnetron sputtering method. In particular, the absorption film may be formed by sputtering using an appropriate target selected, according to the composition, from the group consisting of a chromium (Cr) target, and a chromium (Cr) compound target (a target containing chromium (Cr), and oxygen (O), nitrogen (N), carbon (C) or other elements) in the case of forming by the material containing chromium (Cr), or from the group consisting of a ruthenium (Ru) target, and a ruthenium (Ru) compound target (a target containing ruthenium (Ru), and oxygen (O), nitrogen (N), carbon (C), boron (B) or other elements) in the case of forming by the material containing ruthenium (Ru), and using, as a sputtering gas, a rare gas such as helium (He) gas, neon (Ne) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas, in particular, oxygen (O₂) gas, nitrogen (N₂) gas, a nitrogen oxide (N₂O, NO, NO₂) gas, and a carbon oxide (CO, CO₂) gas, with the rare gas.

An etching mask film having different etching characteristics from that of the absorption film is provided, as a hard mask for the absorption film, on the absorption film at the side remote from the substrate. The etching mask film of the invention contains niobium (Nb). Niobium oxide (NbO) is formed from niobium (Nb) in dry etching using a gas containing oxygen (O). Niobium oxide (NbO) is resistant to the dry etching using a gas containing oxygen (O).

The etching mask film acts as a hard mask in dry etching of the absorption film with using a gas containing oxygen (O). Therefore, the etching mask film is preferably free of elements of metals or metalloids contained in the absorption film, in particular, chromium (Cr) and ruthenium (Ru). The etching mask film is preferably formed in contact with the absorption film. The etching mask film may consist of a single layer or multiple layers.

The etching mask film preferably consists of simple substance of niobium (Nb), however, may be composed of a niobium (Nb) compound containing niobium (Nb) and oxygen (O), for example, niobium oxide (NbO). The niobium (Nb) compound containing niobium (Nb) and oxygen (O) preferably contains niobium (Nb) and oxygen (O) as main components, and has a total content of niobium (Nb) and oxygen (O), on average of the whole film, of preferably not less than 70 at%, more preferably not less than 80 at%, even more preferably 91 at%, further preferably 100 at%. Further, the niobium (Nb) compound containing niobium (Nb) and oxygen (O) preferably has a content of niobium (Nb), on average of the whole film, of preferably not less than 20 at%, more preferably not less than 28 at%, even more preferably not less than 29 at%.

The niobium (Nb) compound containing oxygen (O) may further contain an element or a compound that can be etched by dry etching using a gas containing chlorine (Cl) or a gas containing fluorine (F), and may contains, for example, an element such as silicon (Si), nitrogen (N), carbon (C) and other elements, or a compound of the element.

A content of the element other than niobium (Nb) and oxygen (O) is preferably not more than 30 at%, more preferably not more than 20 at%, on average of the whole film. In this case, a total content of oxygen (O), nitrogen (N) and carbon (C) is preferably not more than 72 at%, on average of the whole film.

The etching mask film containing niobium (Nb) may consist of a single layer or multiple layers. Examples of multiple layers includes a combination of layers containing niobium (Nb) that have different compositions or composition ratios such as a combination of a layer composed of a niobium (Nb) compound containing oxygen (O) and a layer composed of niobium (Nb), and a combination of layers composed of a niobium (Nb) compound containing oxygen (O) that have different composition ratios. Each layer may be a single composition layer or a compositionally graded layer having graded composition. When the etching mask film contains oxygen (O), it is preferable that the oxygen (O) content at the surface side (the side remote from the substrate) is high; or the layer at the surface side is the layer composed of a niobium (Nb) compound containing oxygen (O), and the layer at the substrate side is the layer composed of niobium (Nb) or a layer containing niobium (Nb) and being free of oxygen (O).

As the dry etching using a gas containing chlorine (Cl), in particular, dry etching using a gas containing chlorine (Cl₂) gas, hydrogen chloride (HCl) gas or others is exemplified in the invention. As the dry etching using a gas containing fluorine (F), in particular, dry etching using a gas containing carbon tetrafluoride (CF₄) gas or sulfur hexafluoride (SF₆) gas is exemplified in the invention. The gas containing chlorine (Cl) is preferably free of a gas containing oxygen (O). The gas containing chlorine (Cl) and the gas containing fluorine (F) may contain a rare gas such as helium (He) gas, argon (Ar) gas, krypton (Kr) gas and xenon (Xe) gas.

After the pattern of the absorption film is formed, the etching mask film may be remained in the reflective mask, for example, as a reflectance reducing film for reducing reflectance at a wavelength of light used in inspection such as pattern inspection, or may be removed to be absent on the reflective mask.

When the hard mask film is too thin, the hard mask film may not act as an etching mask, and when the hard mask film is too thick, processing properties may be deteriorated. Thus, the hard mask film has a thickness of preferably not less than 1 nm, more preferably not less than 2 nm, and preferably not more than 20 nm, more preferably not more than 10 nm, however, not limited particular thereto.

The etching mask film can be formed by sputtering. The etching mask film may be formed by sputtering using, as a sputtering target, a niobium (Nb) target and an optional niobium (Nb) compound target (a target containing niobium (Nb), and oxygen (O), nitrogen (N), carbon (C), boron (B) or other elements), and using, as a sputtering gas, a rare gas such as helium (He) gas, argon (Ar) gas, krypton (Kr) gas and xenon (Xe) gas, or by reactive sputtering using, as the sputtering gas, a reactive gas such as an oxygen-containing gas, a nitrogen-containing gas and a carbon-containing gas, in particular, oxygen (O₂) gas, nitrogen (N₂) gas, a nitrogen oxide (N₂O, NO, NO₂) gas, a carbon oxide (CO, CO₂) gas, with the rare gas. The sputtering is preferably performed by a magnetron sputtering method.

In the case that the etching mask film contains oxygen (O), niobium (Nb) is susceptible to natural oxidation, thus, the etching mask film composed of a niobium (Nb) compound containing oxygen (O) can be formed by forming a simple niobium (Nb) film and exposing it to an atmosphere containing oxygen (O) such as the air to oxidize. To oxidize the simple niobium (Nb), the film may be heat-treated.

In addition, another etching mask film (a second etching mask film) that acts as a hard mask in etching of the etching mask film containing niobium (Nb) (a first etching mask film) may by formed on the etching mask film containing niobium (Nb), preferably in contact with the ching mask film containing niobium (Nb). As the second etching mask film, an etching mask film containing chromium (Cr) is exemplified.

The reflective mask blank of the invention may include an etching prevention film between the protection film and the absorption film. The etching prevention film is a film for protecting the protection film and preventing etching to the protection film in dry etching using a gas containing oxygen (O), particularly a gas containing chlorine (Cl) and oxygen (O). Thus, the etching prevention film acts as an etching stopper to the dry etching using a gas containing oxygen (O), particularly a gas containing chlorine (Cl) and oxygen (O). The etching prevention film preferably contains niobium (Nb) or tantalum (Ta). The etching prevention film containing niobium (Nb) or tantalum (Ta) is not etched by etching using a gas containing oxygen (O), particularly a gas containing chlorine (Cl) and oxygen (O). Thus, damages to the protection film can be prevented.

A conductive film (conducting film) used for electrostatic chucking a reflective mask to an exposure apparatus (for example, an EUV scanner) may be formed on the other main surface (back-side surface) which is the surface opposite to the one main surface in the substrate, preferably in contact with the other main surface.

The conducting film preferably has a sheet resistance of not more than 100 Ω/square, and a material for the conducting film is not limited particularly. Examples of materials of the conducting film include, for example, a material containing tantalum (Ta) or chromium (Cr). The material containing tantalum (Ta) may contain oxygen (O), nitrogen (N), carbon (C), boron (B) or other elements, and the material containing chromium (Cr) may contain oxygen (O), nitrogen (N), carbon (C) or other elements. Examples of the materials containing tantalum (Ta) include, for example, simple substance of Ta, and a tantalum (Ta) compound such as TaO, TaN, TaON, TaC, TaCN, TaCO, TaCON, TaB, TaOB, TaNB, TaONB, TaCB, TaCNB, TaCOB and TaCONB. Examples of the materials containing chromium (Cr) include, for example, simple substance of Cr, and a chromium (Cr) compound such as CrO, CrN, CrON, CrC, CrCN, CrCO, CrCON.

The conducting film has a thickness of normally about 20 to 300 nm, however, not limited particularly thereto as long as the thickness is enough to act for electrostatic chucking use. The conducting film is preferably formed so as to have a thickness at which film stresses between the conducting film, and the film(s) and pattern(s) of the film(s) formed at the one main surface (front surface) side are balanced after obtaining the reflective mask, i.e., after forming the pattern of the absorption film. The conducting film may be formed before forming the multilayer reflection film, or after forming all the films on the substrate at the multilayer reflection film side. After forming a part of the films on the substrate at the multilayer reflection film side, the conducting film may be formed, and then the remainder of the films at the multilayer reflection film side may be formed on the substrate. The conducting film can be formed by, for example, a magnetron sputtering method.

The reflective mask blank may include a resist film formed on the side remotest from the substrate. The resist film is preferably an electron beam (EB) resist.

From the reflective mask blank, for example, a reflective mask including a substrate, a multilayer reflection film that is formed on one main surface of the substrate, and a pattern of an absorption film (an absorption film pattern) that is formed in contact with the multilayer reflection film. In a reflective mask, a transfer pattern is formed by a difference in reflectance between a portion where an absorption film is formed and a portion where an absorption film is not formed.

FIG. 2 is a cross-sectional view illustrating an example of a reflective mask of the invention. This reflective mask 10 includes a substrate 1, and on the substrate 1, a multilayer reflection film 2 that is formed in contact with the substrate 1, and a pattern of an absorption film 31 that is formed in contact with the reflection film 2.

A reflective mask of the invention may be manufactured by the method including the steps of:
preparing the reflective mask blank,
optionally forming a resist film on the etching mask film,
forming a resist pattern from the resist film on the etching mask film,
forming a pattern of the etching mask film by etching the etching mask film with using the resist pattern as an etching mask,
forming a pattern of the absorption film by etching the absorption film with using the pattern of the etching mask film as an etching mask,
removing the resist pattern, and
removing the pattern of the etching mask film.

The etching mask film containing niobium (Nb) can be etched by dry etching using a gas containing chlorine (Cl) or a gas containing fluorine (F).

The absorption film is patterned by day etching using a gas containing oxygen (O), and the pattern of the etching mask film acts as an etching mask in dry etching using a gas containing oxygen (O) in dry etching of the absorption film with using a gas containing oxygen (O) since the etching mask film containing niobium (Nb) is not etched by the dry etching using a gas containing oxygen (O).

In the case that another etching mask film (a second etching mask film) that acts as a hard mask in etching of the etching mask film containing niobium (Nb) (a first etching mask film) is formed, a pattern of the second etching mask film can be formed by etching the second etching mask film with using a resist pattern as an etching mask, and a pattern of the first etching mask film can be formed by etching the first etching mask film with using the pattern of the second etching mask film as an etching mask.

In the case that the second etching mask film is an etching mask film containing chromium (Cr), the pattern of the second etching mask film can be formed by dry etching using a gas containing chlorine (Cl) and oxygen (O). In this case, when the absorption film is composed of a material containing chromium (Cr), the pattern of the second etching mask film can be removed by dry etching using a gas containing chlorine (Cl) and oxygen (O) simultaneously with patterning of the absorption film by the dry etching using a gas containing chlorine (Cl) and oxygen (O).

The absorption film composed of a material containing chromium (Cr) can be etched by dry etching using a gas containing chlorine (Cl) and oxygen (O). The absorption film composed of a material containing ruthenium (Ru) can be etched by dry etching using a gas containing oxygen (O), in particular, dry etching using a gas containing oxygen (O) and being free of other gases except for rare gases, or dry etching using a gas containing chlorine (Cl) and oxygen (O).

By forming the pattern of the etching mask film by etching the etching mask film with using a resist pattern as an etching mask, and patterning the absorption film by dry etching using a gas containing oxygen (O) with using the pattern of the etching mask film as an etching mask to form the pattern of the absorption film, compared with the case of forming the pattern of the absorption film by directly forming a resist pattern on the absorption film and then patterning the absorbing film by dry etching using a gas containing oxygen (O) with using the resist pattern as an etching mask, the resist pattern (resist film) can be thinned, and a fine and preferable pattern can be formed.

The resist pattern and the pattern of the etching mask film containing niobium (Nb) can be removed by sulfuric acid-hydrogen peroxide mixture (SPM).

Further, the pattern of the etching mask film containing niobium (Nb) can be removed by dry etching using a gas containing chlorine (Cl) or a gas containing fluorine (F). However, when niobium (Nb) is exposed to a gas containing oxygen (O), niobium (Nb) is oxidized to form niobium oxide (NbO). Niobium oxide (NbO) is hard to remove by dry etching using a gas containing chlorine (Cl) or a gas containing fluorine (F), thus, the pattern of the etching mask film containing niobium (Nb) is preferably removed by sulfuric acid-hydrogen peroxide mixture (SPM). In this case, the pattern of the etching mask film containing niobium (Nb) may be removed continuously with removing the resist pattern.

The pattern of the absorption film and the exposed protection film may be provided to treatment of contacting with sulfuric acid-hydrogen peroxide mixture (SPM), for example, cleaning by sulfuric acid-hydrogen peroxide mixture (SPM).

### EXAMPLES

Examples of the invention are given below by way of illustration and not by way of limitation.

### Example 1

On one main surface of a precision-polished low thermal expansion substrate made of titania-doped SiO₂, a multilayer reflection film in which a molybdenum (Mo) layer having a thickness of 3 nm and a silicon (Si) layer having a thickness of 4 nm, as one pair (cycle), were alternately laminated for 40 pairs (cycles) and the silicon (Si) layer was the uppermost layer was formed by sputtering. Next, a ruthenium (Ru) film having a thickness of 3 nm, as a protection film, was formed on the multilayer reflection film by sputtering. The multilayer reflection film and the protection film had a reflectance of 64% at an incident angle of 6° with respect to EUV light having a wavelength of 13.5 nm.

Next, a chromium nitride (CrN) film (Cr:N=4:1 (atomic ratio)) having a thickness of 45 nm, as an absorption film, was formed on the protection film. The chromium nitride (CrN) film was formed by sputtering with applying a power of 1000W to a chromium (Cr) target while feeding argon (Ar) gas at 20 SCCM and nitrogen (N₂) gas at 10 SCCM.

Next, a niobium oxide (NbO) film (Nb:O=2:5 (atomic ratio)) having a thickness of 2 nm, as an etching mask film, was formed on the absorption film. The niobium (NbO) film was formed firstly by sputtering with applying a power of 750W to a niobium (Nb) target while feeding argon (Ar) gas at 12 SCCM to form a niobium (Nb) film, then oxidizing the niobium (Nb) film by heat treatment in the air at 150 °C for 10 minutes.

Further, on the other main surface of the substrate, a tantalum nitride (TaN) film having a thickness of 70 nm, as a conducting film, was formed by sputtering to obtain a reflective mask blank.

A reflective mask was manufactured from the obtained reflective mask blank. First, a resist film having a thickness of 90 nm was formed on the etching mask film by coating an electron beam (EB) resist, and a resist pattern that includes line-and-space (L/S) patterns having a line width of 50 nm was formed by drawing patterns with using electron (EB) beam, and developing.

Next, the etching mask film was patterned by dry etching using a gas containing sulfur hexafluoride (SF₆) gas with using the resist pattern as an etching mask to form a pattern of the etching mask film. The dry etching was performed by an inductively coupled plasma (ICP) method under the conditions: SF₆ flow rate: 18 SCCM, He flow rate: 130 SCCM, pressure: 5 mTorr (0.67 Pa), ICP power: 325W, and RIE voltage: 190V.

Next, the absorption film was patterned by dry etching using a gas containing chlorine (Cl₂) gas and oxygen (O₂) gas with using the pattern of the etching mask film as an etching mask to form a pattern of the absorption film. The dry etching was performed by an inductively coupled plasma (ICP) method under the conditions: Cl₂ flow rate: 185 SCCM, O₂ flow rate: 55 SCCM, He flow rate: 9.25 SCCM, pressure: 6 mTorr (0.8 Pa), ICP power: 400W, and RIE voltage: 700V.

Next, the remained resist pattern and the pattern of the etching mask film was removed by sulfuric acid-hydrogen peroxide mixture (SPM) to obtain the reflective mask. Fine and preferable patterns of the absorption film having a line width of 50 nm were formed in the obtained reflective mask.

### Comparative Example 1

A reflective mask blank was obtained in the same manner as in Example 1, except that the etching mask film was not formed. Next, a resist pattern was formed directly on the absorption film in the same manner as in Example 1. Next, an attempt was made to form a pattern of the absorption film by patterning the absorption film by dry etching using a gas containing chlorine (Cl₂) gas and oxygen (O₂) gas in the same manner as in Example 1 except that the resist pattern was used as an etching mask. However, the resist pattern disappeared before the pattern of the absorption film was formed, therefore, the pattern of the absorption film could not be formed.

## Claims

1. A reflective mask blank which is a material for a reflective mask used in EUV lithography utilizing EUV light as exposure light, comprising
a substrate,
a multilayer reflection film that is formed on one main surface of the substrate, and reflects the exposure light, and
an absorption film that is formed on the multilayer reflection film, and absorbs the exposure light, wherein
the absorption film consists of a material that can be dry-etched by a gas comprising oxygen (O), and
the reflective mask blank comprises an etching mask film comprising niobium (Nb) on the absorption film.

2. The reflective mask blank of claim 1 wherein the etching mask film comprising niobium (Nb) consists of simple niobium (Nb), or a niobium (Nb) compound comprising niobium (Nb) and oxygen (O).

3. The reflective mask blank of claim 1 or 2 wherein the absorption film comprises chromium (Cr).

4. The reflective mask blank of claim 1 or 2 wherein the absorption film comprises ruthenium (Ru).

5. A manufacturing method of a reflective mask, comprising the step of:
pattering the absorption film of the reflective mask blank of any one of claims 1 to 4 by dry etching using a gas comprising oxygen (O).

6. The manufacturing method of claim 5 comprising the steps of
patterning the etching mask film with using a resist pattern as an etching mask to form a pattern of the etching mask film, and
patterning the absorption film by dry etching using a gas comprising oxygen (O) with using the pattern of the etching mask film as an etching mask.

7. The manufacturing method of claim 6, comprising the step of:
after forming the pattern of the absorption film, removing the pattern of the etching mask film by sulfuric acid-hydrogen peroxide mixture (SPM).
